# EUROPEAN PATENT APPLICATION

(11) **EP 4 574 357 A1**
(43) Date of publication of application: **25.06.2025**
(21) Application number: 23855123.8
(22) Date of filing: 14.08.2023
(51) Int. Cl.: B26B 21/54, B24B 3/48, C23C 30/00, C23C 14/02, C23C 16/02, B26B 21/40

(54) **RAZOR BLADE**

(30) Priority: 16.08.2022 KR 20220102299; 01.06.2023 KR 20230071154
(71) Applicant: Dorco Co., Ltd., Seoul 06773 (KR)
(72) Inventor: LEE, Hyun Ju, Seoul 06773 (KR); JUNG, Hyun Kyu, Seoul 06773 (KR); LEE, Seung Ki, Seoul 06773 (KR); RYU, Kwang Choon, Seoul 06773 (KR); PARK, Min Joo, Seoul 06773 (KR)
(74) Representative: Michalski Hüttermann & Partner Patentanwälte mbB
(86) International application number: PCT/KR2023/012011
(87) International publication number: WO 2024/039156

(57) **Abstract**

A razor blade according to an embodiment of the present invention comprises a substrate having a cutting edge formed at the tip thereof, wherein the thickness (T4) of the substrate as measured at a distance of 4µm from the tip has a value of 1.00 to 1.70µm, the thickness (T250) of the substrate as measured at a distance of 250µm from the tip has a value of 44.00 to 60.56µm, preferably 47.5 to 60.56µm, the ratio of T4 to T250 is 0.032 or less, and the rate of increase of the thickness at a first section included in the region spaced 40 to 100µm apart from the tip is less than the rate of increase of the thickness at a second section included in the region spaced 100µm or greater apart from the tip.

## Description

### TECHNICAL FIELD

The present disclosure relates to a razor blade, and, more particularly, to a razor blade used for cutting hair.

### BACKGROUND

In the case of a razor blade for cutting hair such as a beard, varies in shaving performance and shaving feel depending on the shape and material of the blade, which part essentially cuts the hair, causes significant changes in shaving performance and shaving feel, even with a slight difference in shape.

As a cutting edge of a razor blade becomes thinner, the cutting force of the razor blade becomes lower. The cutting force means the force required for a razor blade to cut a single strand of hair. Accordingly, as the cutting edge of the razor blade becomes thinner, less force is required to cut hair. However, when the cutting edge is excessively thin, the razor blade is prone to bending while cutting hair, which decreases the bending durability of the blade.

Therefore, an optimized design of a razor blade to secure both bending durability and cutting force thereof is required.

### SUMMARY

The purpose of the present disclosure is to provide a razor blade having an optimized profile to lower cutting force of the razor blade and improve bending durability thereof.

The purpose of the present disclosure is to provide a razor blade that provides improved shaving performance and enhanced shaving feeling.

The purposes of the present disclosure are not limited to the above-mentioned purposes, and the following description will allow other purposes not mentioned above to be clearly understood by a person having ordinary skills in the art.

According to the embodiment of the present disclosure to achieve the aforementioned purposes, there is provided a razor blade including a substrate having a cutting edge formed at a tip, wherein: in the substrate, a thickness T4 of the substrate measured at a distance of 4 µm from the tip is between 1.00 µm and 1.70 µm, a thickness T250 of the substrate measured at a distance of 250 µm from the tip is between 44 µm and 60.56 µm, more preferably between 47.5 µm and 60.56 µm, a ratio of the T4 to the T250 is 0.032 or less, and a rate of increase in thickness in a first section in a region distanced 40 µm to 100 µm from the tip is less than a rate of increase in thickness in a second section in a region distanced 100 µm or more from the tip.

Other details of the present disclosure will be described in the detailed description and the drawings below.

According to the embodiments of the present disclosure, at least the following effects may be provided.

It may be possible to secure a razor blade having both lower cutting force and better bending durability compared to a conventional razor blade.

It may be possible to secure a razor blade providing improved shaving performance and enhanced shaving feeling compared to a conventional razor blade.

The effects of the present disclosure are not limited to those described above, and other diverse effects are described herein.

### BRIEF DESCRIPTION OF THE DRAWINGS

FIG. 1 is a view of a schematic profile of a part of a substrate of a razor blade according to an embodiment of the present disclosure.
FIG. 2 is a view for describing a single hair cutting force SHCF.
FIG. 3 is a view for describing the moment of area of the razor blade.
FIG. 4 is a view of a schematic profile of a part of the razor blade according to an embodiment of the present disclosure.
FIG. 5 is an enlarged image of a portion of one surface of a cutting edge of the razor blade according to an embodiment of the present disclosure.
FIG. 6 is a view for describing abraded scratches formed on one surface of the cutting edge of the razor blade according to an embodiment of the present disclosure.
FIG. 7 is a view for describing surface roughness of one surface of the cutting edge of the razor blade according to an embodiment of the present disclosure.
FIG. 8 is a view of a schematic profile of a portion of a conventional razor blade.

### DETAILED DESCRIPTION

The advantages and characteristics of the present disclosure, and methods of achieving them will be clearly understood with reference to the embodiments described below in detail with the accompanying drawings. However, the present disclosure is not limited to the embodiments disclosed below and may be implemented in a variety of forms, the embodiments are merely intended to complete the present disclosure and to allow a person having ordinary skills in the art to fully understand the scope of the present disclosure, and the present disclosure is defined only by the scope of the claims.

In addition, the embodiments described in this specification will be described with reference to cross-sectional views and/or schematic views, which are ideal exemplary views of the present disclosure. Therefore, the shapes in the exemplary views may be modified due to manufacturing techniques and/or tolerances. Furthermore, components in each drawing of the present disclosure may be shown somewhat enlarged or reduced in consideration of convenience of description. The same reference numbers refer to the same components throughout the specification.

Hereinafter, the present disclosure will be described with reference to the drawings for describing a razor blade according to an embodiment of the present disclosure.

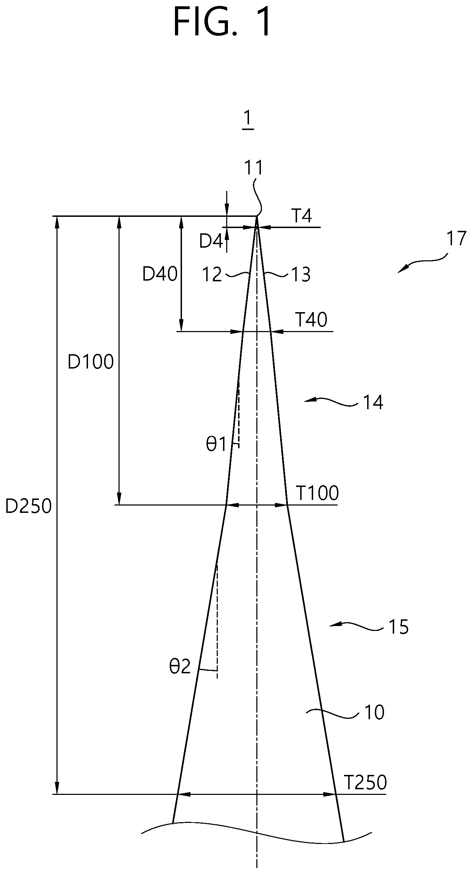

FIG. 1 is a view of a schematic profile of a part of a substrate 10 of a razor blade 1 according to an embodiment of the present disclosure.

Referring to FIG. 1, the razor blade 1 may include a substrate 10 having a cutting edge 17 on which a sharp tip 11 is formed. The substrate 10 may be made of any one of stainless steel, carbon steel, and ceramic, but the present disclosure is not limited thereto.

Both side surfaces 12 and 13 of the cutting edge 17 may include a plurality of facets formed by an abrading wheel. The detailed description of this will be provided below.

In the case of the razor blade according to an embodiment of the present disclosure, compared to a conventional razor blade, the cutting force required to cut hair may be reduced, the bending durability for preventing bending of the razor blade may be improved, and the durability of the razor blade may be maintained. These technical features will be described below.

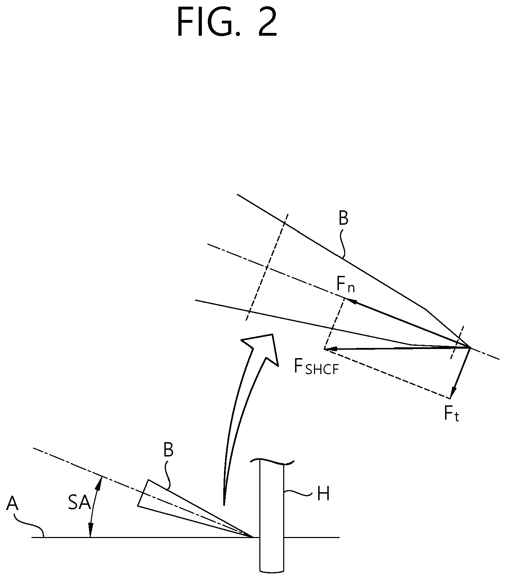

FIG. 2 is a view for describing a single hair cutting force SHCF.

Referring to FIG. 2, in general, a razor blade B may cut hair H by moving while forming a shaving angle SA with respect to the skin surface A.

A Single Hair Cutting Force (SHCF) is the force required for the razor blade B to cut a single strand of hair. Referring to FIG. 2, the single hair cutting force F_{SHCF} may be separated into F_{N} and F_{T} perpendicular to each other. F_{N} may be a force acting in the longitudinal direction of the razor blade B, and F_{T} may be a force acting in a direction perpendicular to the F_{N}.

The F_{N} may be supported by a razor cartridge in which the razor blade B is accommodated, but the razor blade B may be bent by the F_{T}.

In the meantime, when the angle of the razor blade B deviates from an intended value due to bending of the razor blade B, it may negatively impact the shaving feeling. For example, when the razor blade B bends upward to move away from the skin A, miss cuts may occur frequently during shaving, making it difficult to achieve a clean shave. Conversely, when the razor blade B bends downward to get closer to the skin A, it may highly irritate the skin A or cause a wound on the skin A.

Therefore, the razor blade B may need to have a high bending durability to prevent bending thereof. The bending durability refers to the degree of resistance to bending of the razor blade B that may occur, and, as the bending durability is high, the razor blade B is less bent.

In the case of the razor blade 1 according to an embodiment of the present disclosure, the thickness T250 at a position relatively far from the tip 11 may be thick, so that it may be possible to improve a bending durability while maintaining a low cutting force. A detailed description thereof will be provided below with reference to FIGS. 1 to 3.

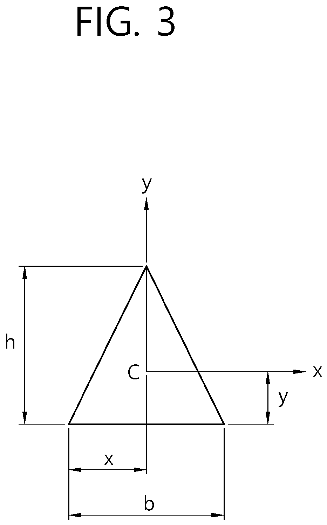

FIG. 3 is a view for describing the moment of area of the razor blade.

Roughly speaking, the razor blade B may have a shape approximately equivalent to an isosceles triangle.

Referring to FIG. 3, b denotes the length of the base of the isosceles triangle, h denotes the height, and, with respect to the centroid C of the isosceles triangle, x = b/2 and y = h/3. Based on this, the second moment of the cross-sectional area of the isosceles triangle in FIG. 3 may be calculated as Ix=b*h³/36, Iy=h*b³/48, and Ixy=0.

As described with reference to FIG. 2, since the razor blade B may be bent by the F_{T}, for the razor blade B, the value of Iy of the second moment of the cross-sectional area may be a value representing the characteristics of the cross-sectional area that resists bending by the F_{T}.

Since Iy=h*b³/48, the value of Iy may be proportional to the cube of b, which represents the length of the base of the isosceles triangle. That is, in the case of the razor blade B, the characteristic of the resistance to bending by the F_{T} may be proportional to the cube of the thickness of the cutting edge.

Referring back to FIG. 1, the thickness T of the substrate 10 measured at a point away from the tip 11 by a distance D is indicated.

In FIG. 1, a distance of 4 µm from the tip 11 is denoted as D4, and the thickness of the substrate 10 measured at a point away from the tip 11 by the D4 is denoted as T4. A distance of 40 µm from the tip 11 is denoted as D40, and the thickness of the substrate 10 measured at a point away from the tip 11 by the D40 is denoted as T40. A distance of 100 µm from the tip 11 is denoted as D100, and the thickness of the substrate 10 measured at a point away from the tip 11 by the D100 is denoted as T100. A distance of 250 µm from the tip 11 is denoted as D250, and the thickness of the substrate 10 measured at a point away from the tip 11 by the D250 is denoted as T250.

According to the above-mentioned rule, it can also be understood how the distances of points not shown in FIG. 1 from the tip 11 and the thicknesses of the substrate 10 measured at the points are denoted. For example, even though not shown in FIG. 1, a distance of 20 µm from the tip 11 is denoted as D20, and the thickness of the substrate 10 measured at a point away from the tip 11 by the D20 is denoted as T20.

In addition, as shown in FIG. 1, a distance D from the tip 11 may be obtained by measuring distance from the tip 11 along the bisecting line of the substrate 10.

In the meantime, the razor blade 1 may obliquely approach hair at a predetermined angle with respect to the skin. Furthermore, during shaving, hair may be completely cut when being somewhat laid down by the razor blade. Therefore, the diameter of hair is approximately 100 µm, but the part of the razor blade 1 that is directly in contact with hair to cut the hair during shaving is within the D200 from the tip 11. Accordingly, in order to increase the value of Iy representing the characteristics of the cross-sectional area that resists bending by the F_{T} as described with reference to FIGS. 2 and 3, the thickness of the portion between D100 and D250 must be thick, which may improve the bending durability of the razor blade 1 while minimizing the deformation of the cutting edge 17 of the razor blade 1 in the process of cutting hair.

In the meantime, the T4 of the cutting edge 17 may be related to the cutting force of the razor blade 1. In general, the cutting force may be determined at the moment when the tip of the cutting edge 17 cuts in hair, which may be related to the T4. Generally, as the T4 becomes thinner, the cutting force may become lower.

Therefore, in the case of the razor blade 1 according to this embodiment of the present disclosure, compared to conventional razor blades, the T4 may be thinner, and the rate of increase in the thickness of the portion between D100 and D250 may be higher than the rate of increase in the thickness of the portion between D40 and D100. As a result, in the case of the razor blade 1 according to this embodiment, compared to the conventional razor blades, the cutting force may be lower, the deformation of the cutting edge 17 of the razor blade 1 may be minimized in the process of cutting hair, and providing the technical advantage of the improved bending durability.

**[Table 1]**

| Major Classification | Classification | Range of Figures | |
|---|---|---|---|
| | | min | max |
| Tip Profile | T4(µm) | 1.00 | 1.70 |
| | T8(µm) | 1.90 | 2.72 |
| | T16(µm) | 3.30 | 4.80 |
| | T40(µm) | 6.50 | 10.00 |
| | T100(µm) | 16.50 | 24.00 |
| | T250(µm) | 44.00(more preferably, 47.50) | 60.56 |
| Ratio | T4/T8 | 0.385 | 0.789 |
| | T4/T16 | 0.233 | 0.455 |
| | T4/T40 | 0.110 | 0.231 |
| | T4/T100 | 0.044 | 0.091 |
| | T4/T250 | 0.017 | 0.032 |
| | T16/T250 | 0.054 | 0.109(more preferably, 0.101) |
| Angle (°) | T40 to T100 | 4.62 (more preferably, 4.76) | 6.65 |
| | T100 to T250 | 5.24 (more preferably, 5.90) | 6.95 |

Table 1 describes profiles of portions within D250 of the substrate 10 of the razor blade 1 according to an embodiment of the present disclosure. As shown in Table 1 above, in the case of the substrate 10 of the razor blade 1 according to this embodiment, T4 may have a thickness of 1.00 µm to 1.70 µm. Considering that T4 of a substrate of a conventional razor blade has a thickness of 2 µm or more, the T4 of the substrate 10 of the razor blade 1 according to this embodiment is considerably thinner than that of the conventional razor blade. Consequently, the cutting force of the razor blade 1 according to the embodiment may be lower than that of the conventional razor blade.

In addition, referring to Table 1 and FIG. 1, an angle θ1 of a portion 14 (hereinafter, referred to as a "first portion") between D40 to D100 may be 4.62 degrees to 6.65 degrees, more preferably, 4.76 degrees to 6.65 degrees. While an angle θ2 of a portion 15 (hereinafter, referred to as a "second portion") between D100 and D250 may be 5.24 degrees to 6.95 degrees, more preferably, 5.90 degrees to 6.95 degrees.

The angle θ1 may refer to an angle between one surface of the first portion 14 and the central axis of the substrate 10, and the angle θ2 may refer to an angle between one surface of the second portion 15 and the central axis of the substrate 10. The central axis of the substrate 10 may refer to a bisector bisecting the tip 11 or an axis passing through the centroid of the substrate 10 and the tip 11.

This is means that, in the case of the substrate 10 of the razor blade 1 according to the embodiment, the rate of increase in the thickness of the first portion 14 (the portion between D40 and D100) may be lower than the rate of increase in the thickness of the second portion 15 (the portion between D100 and D250). Accordingly, one surface of the substrate 10 in the first portion14 and one surface of the substrate 10 in the second portion 15 may form an obtuse angle.

In addition, referring to Table 1, T250 of the substrate 10 of the razor blade 1 according to this embodiment may have a thickness of 44.00 µm to 60.56 µm, more preferably, a thickness of 47.50 µm to 60.56 µm.

In the case of the substrate 10 of the razor blade 1 according to the embodiment, T250 may be formed relatively thick, and T4 may be formed relatively thin, so that the ratio of the T4 to the T250 (T4/T250) may be 0.032 or less. Desirably, the ratio, T4/T250, may have a value ranging from 0.017 to 0.032.

In the case of the substrate 10 of the razor blade 1 according to the embodiment, the rate of increase of thickness in an arbitrary first section in the first portion 14 may be lower than the rate of increase of thickness in an arbitrary second section in the second portion 15. In addition, one surface of the substrate 10 in the first section and one surface of the substrate 10 in the second section may form an obtuse angle.

Furthermore, the angle between one surface of the substrate 10 and the central axis of the substrate 10 in the first section may be less than the angle between one surface of the substrate 10 and the central axis of the substrate 10 in the second section.

As described above, in the case of the substrate of the razor blade 1 according to the embodiment, the rate of increase in the thickness of the second portion 15 may be higher than the rate of increase in the thickness of the first portion 14, so that the deformation of the cutting edge 17 of the razor blade 1 may be minimized and the bending durability may be improved in the process of cutting hair.

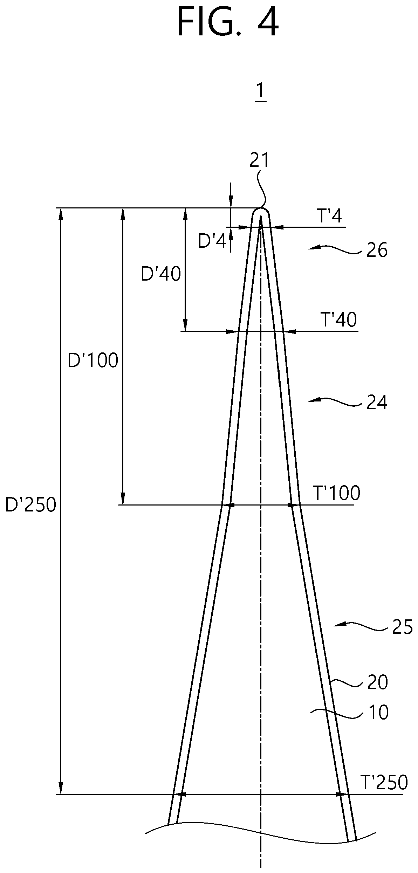

FIG. 4 is a view of a schematic profile of a part of a razor blade 1 according to an embodiment of the present disclosure.

Referring to FIG. 4, the razor blade 1 according to an embodiment of the present disclosure may further include a coating layer 20 stacked on a substrate 10.

The coating layer 20 may include at least one metal coating layer. The metal coating layer may include one or more of CrB, CrC, and DLC. However, the present disclosure is not limited thereto. The metal coating layer may supplement the rigidity of the substrate 10.

**[Table 2]**

| Major Classification | Classification | Range of Figures | |
|---|---|---|---|
| | | min | max |
| Tip Profile | T'4(µm) | 1.36 | 2.28 (more preferably, 2.06) |
| | T'8(µm) | 2.31 | 3.40 (more preferably, 3.08) |
| | T'16(µm) | 3.66 | 5.48 (more preferably, 5.16) |
| | T'40(µm) | 6.86 | 10.68 (more preferably, 10.36) |
| | T'100(µm) | 16.86 | 24.68 (more preferably, 24.36) |
| | T'250(µm) | 44.49 (more preferably, 47.86) | 61.24 (more preferably, 60.92) |
| Ratio | T'4/T'8 | 0.442 | 0.892 |
| | T'4/T'16 | 0.264 | 0.573 (more preferably, 0.563) |
| | T'4/T'40 | 0.131 | 0.305 (more preferably, 0.300) |
| | T'4/T'100 | 0.056 | 0.133 (more preferably, 0.122) |
| | T'4/T'250 | 0.022 | 0.047 (more preferably, 0.043) |
| | T'16/T'250 | 0.060 | 0.123 (more preferably, 0.108) |
| Angle (°) | T'40 to T'100 | 4.62 (more preferably, 4.76) | 6.65 |
| | T'100 to T'250 | 5.24 (more preferably, 5.90) | 6.95 |

Table 2 describes profiles of portions within D'250 of the razor blade 1 including the coating layer 20 according to an embodiment of the present disclosure. FIG. 4 and Table 2 show a thickness T' of the razor blade 1 measured at a distance D' from a tip 21 of the coating layer 20. The thickness T' of the razor blade 1 may mean the thickness including the substrate 10 and the coating layer 20.

In FIG. 4 and Table 2, a distance of 4 µm from the tip 21 of the coating layer is denoted as D'4, and the thickness of the razor blade 1 measured at the D'4 is denoted as T'4. A distance of 40 µm from the tip 21 of the coating layer is denoted as D'40, and the thickness of the razor blade 1 measured at the D'40 is denoted as T'40. A distance of 100 µm from the tip 21 of the coating layer is denoted as D'100, and the thickness of the razor blade 1 measured at the D'100 is denoted as T'100. A distance of 250 µm from the tip 21 of the coating layer is denoted as D'250, and the thickness of the razorblade 1 measured at the D'250 is denoted as T'250.

Based on the above-described rule, it can also be understood how to denote a distance from the tip 21 of the coating layer not shown in FIG. 4 and Table 2 and a thickness of the razor blade 1 measured at the distance. For example, although not shown in FIG. 4 and Table 2, a distance of 20 µm from the tip 21 of the coating layer is denoted as D'20, and the thickness of the razor blade 1 measured at the D'20 is denoted as T'20.

In addition, as shown in FIG. 4, a distance D' from the tip 21 of the coating layer may be measured along the bisecting line of the razor blade 1.

Referring to Table 2, T'4 of the razor blade 1 according to this embodiment may have a thickness of 1.36 µm to 2.28 µm, more preferably, 1.36 µm to 2.06 µm.

Furthermore, referring to Table 2, the angle of a portion 25 (hereinafter, referred to as a "fourth portion") between D'100 and D'250 may be 5.24 degrees to 6.95 degrees, more preferably, 5.90 degrees to 6.95 degrees, while the angle of a portion 24 (hereinafter, referred to as a "third portion") between D'40 and D'100 may be 4.62 degrees to 6.65 degrees, more preferably, 4.76 degrees to 6.65 degrees. The comparison of Tables 1 and 2 shows that the angles of the first portion 14 and the third portion 24 may substantially be in the same range, and the angles of the second portion 15 and the fourth portion 25 may substantially be in the same range.

This means that, in the case of the razor blade 1 according to this embodiment, the rate of increase in the thickness of the third portion 24 (the portion between D'40 and D'100) may be lower than the rate of increase in the thickness of the fourth portion 25 (the portion between D'100 and D'250). Accordingly, one surface of the razor blade 1 in the third portion 24 and one surface of the razor blade 1 in the fourth portion 25 may form an obtuse angle.

In addition, referring to Table 2, T'250 of the razor blade 1 according to this embodiment may have a thickness of 44.49 µm to 61.24 µm, more preferably, a value of 47.86 µm to 60.92 µm.

In the case of the razor blade 1 according to the embodiment, T'250 may be relatively thick, and T'4 may be relatively thin, so that the ratio of the T'4 to the T'250 (T'4/ T'250) may have a value of 0.047 or less. More preferably, the ratio, T'4/T'250, may have a value ranging from 0.022 to 0.043.

In the case of the razor blade 1 according to this embodiment, the rate of increase in thickness in an arbitrary third section in the third portion 24 may be lower than the rate of increase in thickness in an arbitrary fourth section in the fourth portion 25. In addition, one surface of the razor blade 1 in the third section and one surface of the razor blade 1 in the fourth section may form an obtuse angle.

Furthermore, the angle between one surface of the razor blade 1 and the central axis of the razor blade 1 in the third section may be less than the angle between one surface of the razor blade 1 and the central axis of the razor blade 1 in the fourth section. The central axis of the razor blade 1 may refer to a bisector bisecting the tip 21 of the coating layer or an axis passing through the centroid of the razor blade 1 and the tip 21 of the coating layer.

**[Table 3]**

| Major Classification | Classification | | Ratio (Thickness of Razor Blade/Thickness of Substrate) |
|---|---|---|---|
| | | min | max |
| Tip Profile | T'4/T4 | 1.212 | 1.680 (more preferably, 1.360) |
| | T'8/T8 | 1.132 | 1.358 (more preferably, 1.185) |
| | T'16/T16 | 1.075 | 1.206 (more preferably, 1.109) |
| | T'40/T40 | 1.036 | 1.100 (more preferably, 1.055) |
| | T'100/T100 | 1.015 | 1.041 (more preferably, 1.022) |
| | T'250/T250 | 1.006 | 1.015 (more preferably, 1.008) |

Referring to Table 3, in the case of the razor blade 1 according to this embodiment, in a portion 26 (hereinafter, referred to as a "fifth portion") between T'4 and T'16, the ratio of the thickness of the razor blade 1 to the thickness of the substrate 10 may have a value of 1.075 or more. In addition, the ratio of the thickness of the razor blade 1 to the thickness of the substrate 10 in the third portion 24 and the fourth portion 25 may generally have a value of less than 1.075. Therefore, in the case of the razor blade 1 according to this embodiment, in general, the ratio of the thickness of the razor blade 1 to the thickness of the substrate 10 in the third section and the fourth section may be lower than the ratio of the thickness of the razor blade 1 to the thickness of the substrate 10 in an arbitrary fifth section in the fifth portion 26 (the portion between D'4 and D'16).

The razor blade 1 according to this embodiment may include at least one metal coating layer and a lubrication coating layer laminated on top of the metal coating layer on the substrate 10. The lubrication coating layer may include polytetrafluoroethylene (PTFE). However, the present disclosure is not limited thereto.

The lubrication coating layer may reduce the frictional force between the razor blade and the skin.

An adhesive coating layer based on at least one of Cr, CrB, and CrC may be further included between the metal coating layer and the lubrication coating layer. The adhesive coating layer may enhance adhesion between the metal coating layer and the lubrication coating layer.

The coating layer 20 may include at least one of a metal coating layer, an adhesive coating layer, and a lubrication coating layer.

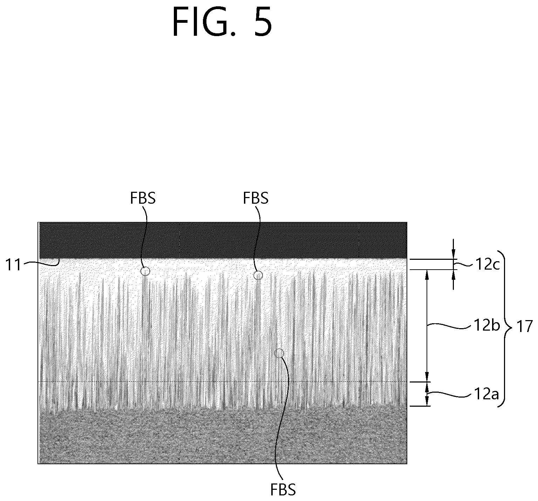

FIG. 5 is an enlarged image of a portion of one surface of the cutting edge 17 of the razor blade 1 according to an embodiment of the present disclosure.

Referring to FIG. 5, the one surface of the cutting edge 17 of the razor blade 1 may include a first facet region 12a and a facet brake region 12b. Depending on the embodiments, the one surface of the cutting edge 17 of the razor blade 1 may further include a second facet region 12c.

In FIG. 5, a first facet is represented as a dark abraded scratch, and a second facet is represented as a bright abraded scratch. Referring to FIG. 5, a plurality of second facets may be formed between the tip 11 and a plurality of first facets.

The facet brake region 12b may be a region in which the plurality of first facets and the plurality of second facets coexist. Facet brake spots FBS where the first facet and the second facet intersect may be irregularly distributed within the facet brake region 12b. Although only some of the facet brake spots FBS are shown in FIG. 5, there may be the facet brake spots FBS almost all over the area above the dark abraded scratches in FIG. 5.

The first facet region 12a may be a region including the plurality of first facets but no second facets.

The second facet region 12c may be a region including the plurality of second facets but no first facets.

The facet brake region 12b may be formed between the tip 11 of the substrate 10 and D420, and may be formed even to the end of the first facet region 12a.

In the case of the embodiment in which the second facet region 12c exists, the second facet region 12c may be formed within a distance D16 from the tip 11, and the facet brake region 12b may be formed within a distance D420 from the second facet region 12c or between a distance D16 and a distance D420.

The first facet region 12a may be formed within a distance D280 from the facet brake region 12b.

The first facet may be formed by a first abrading wheel using cubic boron nitride (CBN) having relatively coarse and sparse grains. The second facet may be formed by a second abrading wheel having relatively fine and dense grains, which is different from the first abrading wheel.

In the case of the razor blade 1 according to this embodiment, the plurality of first facets may be formed on both side surfaces 12 and 13 or one side surface of the substrate 10 by the first abrading wheel. Thereafter, on a first abraded surface on which the plurality of first facets are formed, the plurality of second facets may be formed within a distance D420 from the tip 11 by the second abrading wheel.

Facet brake spots FBS may be discontinuously formed at the point where a first abrading process using the first abrading wheel and a second abrading process using the second abrading wheel intersect, forming the facet brake region 12b.

When different facets are formed by performing the second abrading process on a first abraded surface on which a first facet is formed after performing the first abrading process for forming the first facet, the first facet and a second facet may respectively form a predetermined angle. In general, the angle of the second facet may be greater than that of the first facet based on the bisector of the substrate 10.

Therefore, in the case of a razor blade in which the facet brake spots FBS where the first facet and the second facet intersect are continuously formed, during shaving, only the second facet is in contact with hair and involved in cutting the hair, but the first facet can hardly be in contact with the hair and is thus not involved in cutting the hair. In this case, while the razor blade is cutting the hair, a cutting edge cannot continuously spread the hair, resulting in abnormal cutting of the hair.

However, in the case of the razor blade 1 according to this embodiment, the facet brake spots FBS where the first facet and the second facet intersect may be discontinuously formed within a distance D420 including D200 from the tip 11. Furthermore, as described above, the region within the distance D200 from the tip 11 may be the region where the razor blade 1 is directly in contact with hair during the shaving process.

In the case of the razor blade 1 according to this embodiment, even though the first facet and the second facet may respectively form a predetermined angle, since the facet brake spots FBS may be discontinuously formed within the distance D420 from the tip 11, in the process of cutting hair, the plurality of first facets and the plurality of second facets may remain in contact with the hair, and the cutting edge may continuously spread the hair. In addition, because an angle θ2 of a region between D100 and D250 may be larger than an angle θ1 of a region between D40 and D100, the hair may be continuously spread better.

More specifically, because the first facets and the second facets may coexist on a line parallel to the tip 11 within the distance D420 from the tip 11, the second facets on the same line parallel to the tip 11 may be in contact with hair even when some of the first facets are not in contact with the hair. As a result, during the process of cutting the hair, the plurality of first facets and the plurality of second facets may remain in contact with the hair.

As a result, the performance of cutting hair may be improved, and a cleaner shave and a smoother feeling of shaving may be provided.

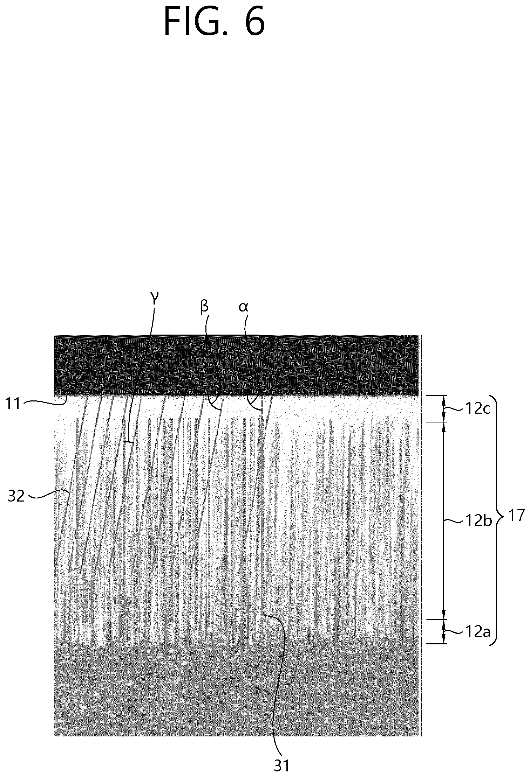

FIG. 6 is a view for describing abraded scratches 31, 32 formed on one surface of the cutting edge 17 of the razor blade 1 according to an embodiment of the present disclosure.

Referring to FIG. 6, a first abraded scratch 31 forming the first facet and a second abraded scratch 32 forming the second facet may not be parallel to each other. That is, the first abraded scratch 31 and the second abraded scratch 32 may intersect to form respective predetermined angles γ within the facet brake region 12b.

The first abraded scratch 31 and the second abraded scratch 32 may intersect at an angle γ of less than 10 degrees.

An angle α between the first abraded scratch 31 forming the first facet and a line extended from the tip 11 may be 88 to 90 degrees. Preferably, the angle α may be 88.5 to 89.8 degrees, more preferably, 89 to 89.5 degrees.

An angle β between the second abraded scratch 32 forming the second facet and the line extended from the tip 11 may be 80 to 90 degrees. Preferably, the angle β may be 82 to 87 degrees, more preferably, 84 to 85 degrees.

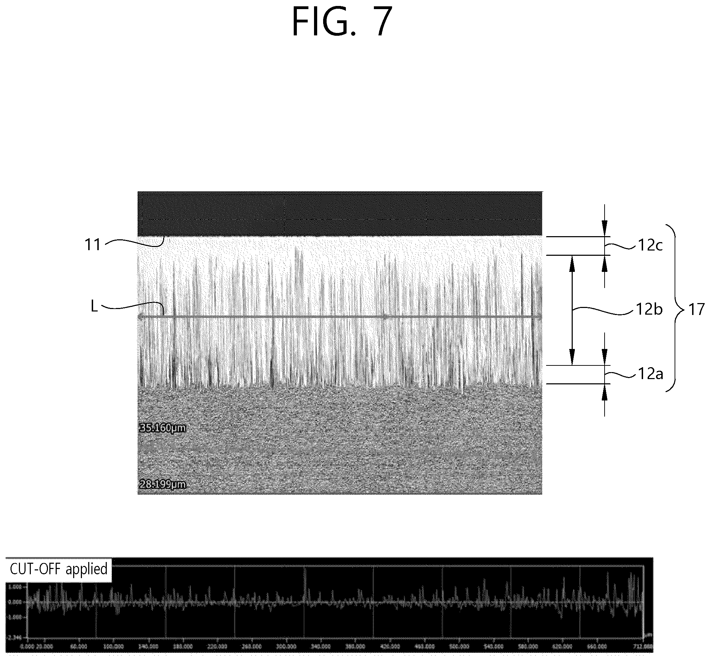

FIG. 7 is a view for describing the surface roughness of one surface of the cutting edge 17 of the razor blade 1 according to an embodiment of the present disclosure.

The surface roughness means the degree of roughness on the surface.

Although there are a range of methods of measuring surface roughness, in the present disclosure, a method of measuring surface roughness on a measurement line L parallel to the line extended from the tip 11 of the substrate 10 was used, and the center line average calculation method (Ra) was used within a reference length (0.08 mm).

The graph in FIG. 7 shows the surface roughness measured in the facet brake region 12b.

The surface roughness measured in the facet brake region 12b was 150 nm to 280 nm, the surface roughness measured in the first facet region 12a was 300 nm to 400 nm, and the surface roughness measured in the second facet region 12c was 1 nm to 50 nm.

The facet brake region 12b and the first facet region 12a may be distinguished by surface roughness. For example, a region having a surface roughness of 300 nm or more may be classified as the first facet region 12a, and a region having a surface roughness of 300 nm or less may be classified as the facet brake region 12b.

In addition, the facet brake region 12b and the second facet region 12c may be distinguished by surface roughness. For example, a region having a surface roughness of 100 nm or more may be classified as the facet brake region 12b, and a region having a surface roughness of 100 nm or less may be classified as the second facet region 12c. Alternatively, a region having a surface roughness of 150 nm or more may be classified as the facet brake region 12b, and a region having a surface roughness of 150 nm or less may be classified as the second facet region 12c. A region having a surface roughness of 50 nm or more may be classified as the facet brake region 12b, and a region having a surface roughness of 50 nm or less may be classified as the second facet region 12c.

When the level of the surface roughness of the substrate is excessively low, the adhesion between the metal coating layer and the substrate may be low so that the substrate and the metal coating layer may be separated from each other. In this case, it may be difficult to form the metal coating layer having a thickness of more than 100 nm to 200 nm.

In contrast, when the level of the surface roughness of the substrate is excessively high, the thickness of the metal coating layer may be changed by curves present on the surface of the substrate. In addition, when the curves present on the surface of the substrate are filled with the metal coating layer, air voids may be formed due to the growth rate of the metal coating layer. When the air voids are formed, the substrate may be corroded because it may be exposed to the outside, and the adhesion between the metal coating layer and the substrate may be deteriorated due to the air voids so that the substrate and the metal coating layer may be separated from each other.

As described above, the first abraded scratch 31 and the second abraded scratch 32 may be formed on the surface of the substrate 10, and the regions 12a, 12b, and 12c may have their respect surface roughness as described above. As a result, the surface area of the substrate 10 of the razor blade 1 according to this embodiment may be widened so that the substrate 10 and the metal coating layer 20 may firmly adhere to each other.

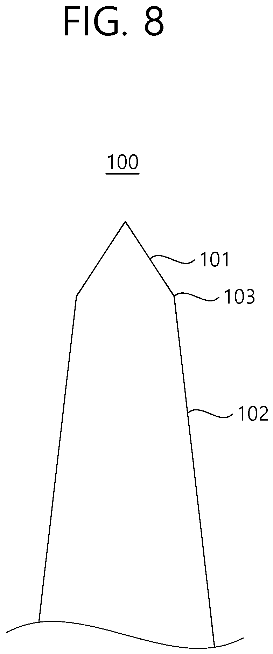

FIG. 8 is a view of a schematic profile of a portion of a conventional razor blade 100.

Referring to FIG. 8, in the case of the conventional razor blade 100, a first facet 101 and a second facet 102 may be clearly separated by a boundary 103. That is, in the case of the conventional razor blade 100, the boundary 103 dividing the first facet 101 and the second facet 102 may be formed in a linear shape.

After performing the first abrading process for forming the first facet 101, the second facet 102 may be formed by carrying out the second abrading process on the first abraded surface on which the first facet 101 has been formed. Accordingly, the first facet 101 and the second facet 102 may form an obtuse angle at the boundary 103 so that the razor blade 100 may have an outwardly convex profile.

However, in the case of the razor blade 1 according to the above-mentioned embodiment of the present disclosure, compared to the conventional razor blade 100, T4 may be formed smaller, and T250 may be formed larger. In order for the razor blade 1 to have such a profile, the T4 and the T250 must be in different facet regions, and, compared to the conventional razor blade 100, the angle between the first facet and the second facet should be closer to 180 degrees (see FIG. 1). The profile cannot be obtained by a conventional abrading process in which the first facet 101 and the second facet 102 are clearly distinguished.

As described above, the razor blade 1 according to the embodiment of the present disclosure may have a profile in which the region where the plurality of first facets exist and the region where the plurality of second facets exist are smoothly connected as a whole by an abrading process of forming the facet brake region 12b in which some of the plurality of first facets overlaps some of the plurality of second facets.

A person having ordinary skills in the art to which the present disclosure pertains may be able to understand that the present disclosure can be implemented in other specific forms without changing its technology or essential features. Therefore, it should be understood that the above-described embodiments are illustrative in all respects and not limiting. The scope of the present disclosure is defined by the following claims rather than the detailed description above, and all changes or modifications derived from the meaning and scope of the claims and their equivalent concepts should be construed as being included in the scope of the present disclosure.

## Claims

1. A razor blade comprising a substrate having a cutting edge formed at a tip, wherein: in the substrate,
a thickness T4 of the substrate measured at a distance of 4 µm from the tip is between 1.00 µm and 1.70 µm;
a thickness T250 of the substrate measured at a distance of 250 µm from the tip is between 44 µm and 60.56 µm, more preferably between 47.5 µm and 60.56 µm;
a ratio of the T4 to the T250 is 0.032 or less; and
a rate of increase in thickness in a first section in a region distanced 40 µm to 100 µm from the tip is less than a rate of increase in thickness in a second section in a region distanced 100 µm or more from the tip.

2. The razor blade of claim 1, wherein an angle between one surface of the substrate and a central axis of the substrate in the first section is smaller than an angle between the one surface of the substrate and the central axis in the second section.

3. The razor blade of claim 2, wherein, in the first section, the angle between the one surface of the substrate and the central axis is between 4.76 degrees and 6.65 degrees.

4. The razor blade of claim 2, wherein, in the second section, the angle between the one surface of the substrate and the central axis is between of 5.9 degrees and 6.95 degrees.

5. The razor blade of claim 1, wherein one surface of the substrate in the first section and one surface of the substrate in the second section form an obtuse angle.

6. The razor blade of claim 1, wherein the ratio of the T4 to the T250 is between 0.017 and 0.032.

7. The razor blade of claim 1, further comprising a coating layer stacked on the substrate, wherein a rate of increase in thickness in a third section in a region 40 µm to 100 µm away from a tip of the coating layer is lower than a rate of increase in thickness in a fourth section in a region 100 µm or more from the tip of the coating layer.

8. The razor blade of claim 7, wherein, in a fifth section closer to the tip of the coating layer than the third section, a ratio of the thickness including the substrate and the coating layer to the thickness of the substrate is 1.075 or more, more preferably, 1.075 to 1.109.

9. The razor blade of claim 8, wherein a ratio of the thickness including the substrate and the coating layer to the thickness of the substrate in the third section and the fourth section are less than that in the fifth section.

10. The razor blade of claim 7, wherein, at a distance of 4 µm from the tip of the coating layer, the thickness including the substrate and the coating layer is between 1.36 µm and 2.28 µm, more preferably between, 1.36 µm and 2.06 µm.

11. The razor blade of claim 7, wherein, at a distance of 250 µm from the tip of the coating layer, the thickness including the substrate and the coating layer is between 44.49 µm and 61.24 µm, more preferably between 47.86 µm and 60.92 µm.

12. The razor blade of claim 7, wherein a ratio of the thickness including the substrate and the coating layer at a distance of 4 µm from the tip of the coating layer to the thickness including the substrate and the coating layer at a distance of 250 µm from the tip of the coating layer is between 0.022 and 0.047, more preferably, between 0.022 and 0.043.

13. The razor blade of claim 1, wherein the substrate includes:
a plurality of first facets;
a plurality of second facets formed between the tip and the plurality of first facets;
a facet brake region in which facet brake spots having the plurality of first facets and the plurality of second facets intersect; and
a first facet region including the plurality of first facets but not including the plurality of second facets.

14. The razor blade of claim 13, wherein the facet brake region is formed within 420 µm from the tip.

15. The razor blade of claim 13, wherein the facet brake region is formed at a distance of more than 16 µm from the tip.

16. The razor blade of claim 13, comprising a second facet region including the plurality of second facets but not including the plurality of first facets.

17. The razor blade of claim 13, wherein a surface roughness value of the facet brake region is lower than a surface roughness value of the first facet region.

18. The razor blade of claim 17, wherein the surface roughness value (Ra) of the facet brake region is 300 nm or less, and the surface roughness value (Ra) of the first facet region is 300 nm to 400 nm.

19. The razor blade of claim 17, wherein the surface roughness value (Ra) of the facet brake region is 150 nm to 280 nm.
